# EUROPEAN PATENT SPECIFICATION

(11) **EP 0 414 140 B1**
(45) Date of publication and mention of the grant of the patent: **09.01.2002**
(21) Application number: 90115760.2
(22) Date of filing: 17.08.1990
(51) Int. Cl.: H01L 21/48, H05K 3/10, C23C 18/14, G03C 1/725

(54) **Light transmission paste and metallic copper deposition method using same**
Lichtdurchlässige Paste und Absetzverfahren für metallisches Kupfer, das diese Paste verwendet
Pâte transparente à la lumière et procédé de dépôt de cuivre métallique utilisant cette pâte

(30) Priority: 22.08.1989 JP 21644989
(43) Date of publication of application: 27.02.1991
(73) Proprietor: MATSUSHITA ELECTRIC INDUSTRIAL CO., LTD., Kadoma-shi, Osaka 571-8501 (JP)
(72) Inventor: Asano, Takahiro, Moriguchi-shi, Osaka-fu (JP); Mizuguchi, Shinichi, Katano-shi, Osaka-fu (JP)
(74) Representative: Eisenführ, Speiser & Partner

(56) References cited:
- EP-A- 0 402 966
- US-A- 3 056 881
- US-A- 3 451 813
- US-A- 3 671 249
- US-A- 3 928 670

## Description

### BACKGROUND OF THE INVENTION

The present invention relates to a circuit forming method.

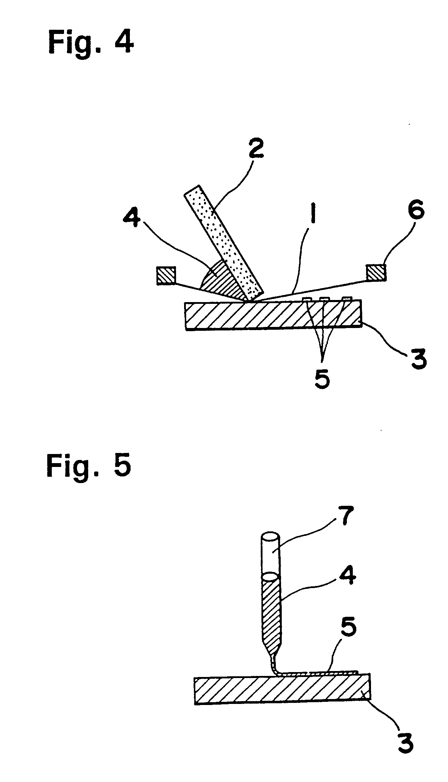

Circuit pattern formation for conventional hybrid IC was effected by a printing method on an alumina ceramic substrate. The fundamental component in the printing method is composed of a screen 1 which has an empty hole corresponding to the circuit pattern to be drawn on the substrate and a squeegee 2 as described in Fig. 4. The screen 1 is retained in parallel to the substrate 3 and in a position of approximately 0.25mm through 2.0mm of the surface of the substrate 3. A conductive paste 4 which forms a pattern 5 is placed on the screen 1. The conductive paste 4 is depressed by moving the squeegee 2 while depressing the screen 1 and moving them together. As a result, the conductive paste 4 is moved onto the substrate 3 from the empty hole portion in the screen 1, and the patterns 5 are formed on the substrate 3.

It has been proposed recently that the patterns should be formed on the substrate by a drawing method. The conductive paste 4 is filled into a paste cartridge 7. The paste cartridge 7 is formed cylindrical, is contracted in its lower end portion, and is provided with an empty hole of 0.06 through 2mm in diameter. The paste which is in the cartridge having a certain diameter hole at lower end portion by the pressure application through the air or the like upon the upper end portion of the paste cartridge 7. By the movement of the paste cartridge 7 and with paste discharging being performed, the pattern 5 of a given line width is drawn.

In the above printing method, the screen 1 must be exchanged when the pattern to be obtained has been exchanged. The screen 1 is expanded by a certain number of printing operations if the pattern is the same. Thus, a positional shift is caused in the printed pattern 5. Therefore, the screen must be exchanged on the way. A uniform screen 1 is not always available, when the screen has to be exchanged, because of the working accuracy of the screen frame, the accuracy necessary when the screen 1 is pasted on the frame, and so on. Therefore, when exchanging the screen 1, adjustments such as new positional alignment and parallel arrangement of the substrate 3 and the screen 1 are necessary. Since it takes about thirty minutes at least for the adjustment, this reduces the operation rate of the hybrid IC production line.

When the pattern 5 is designed and tested, about four days are required to make the screen, so that the development period is extended.

In the drawing method, a program with input of pattern coordinates has only to be changed even in the changes of the pattern 5, so that this hardly causes a stop of the hybrid IC production line. But the empty hole in the tip end portion of the paste cartridge 7 at this time is restricted to 0.06 to 2mm in diameter, also is basically pattern formed with the lines, with the disadvantage that the productivity is extremely lower as compared with the printing.

Recently a method of making a pattern forming circuit with no reduction in the operation rate of the hybrid IC production line even in the case where the substrate is different in pattern has been obtained and been made available even for mass production. In one example, the disproportionation reaction of cuprous oxide is used.

The reaction expressed by ${\text{2Cu}}^{\text{+}} {\text{⇄ Cu}}^{\text{o}} {\text{+ Cu}}^{\text{2+}}$is caused in a portion where light of 280nm to 640nm is applied in a weak acidic environment, such as in a 0.002N sulfic acid aqueous solution, so as to produce metallic copper, so that the metallic copper may be selectively educed to form the pattern.

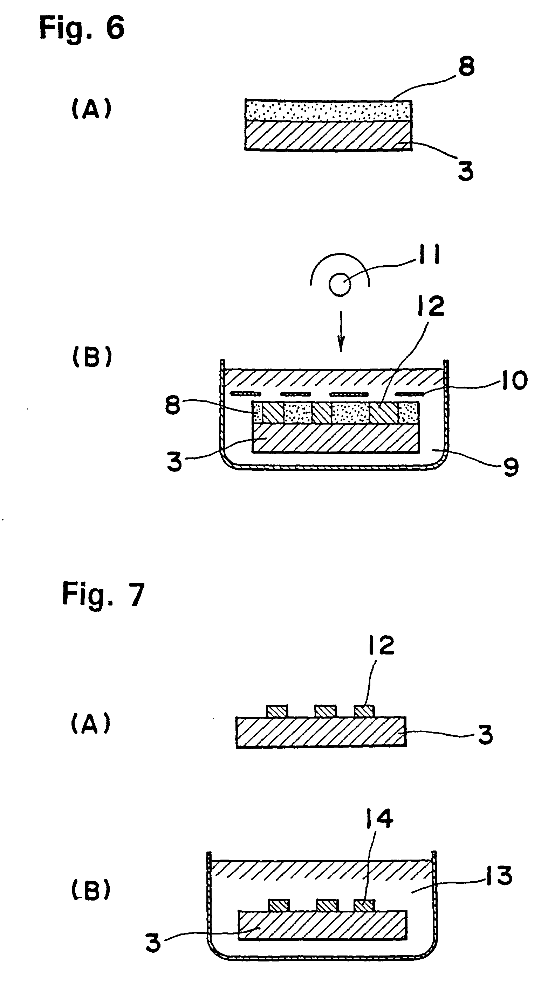

In order to cause disproportionation of cuprous oxide, light of 280nm to 640nm has to be applied in a weak acidic. As shown in Fig. 6 (A), to the cuprous oxide 8 was applied on the substrate 3 to form the pattern. Then, as shown in Fig. 6 (B), it was dipped into a weak acidic aqueous solution such as dilute sulfuric acid or the like. The light of the light source 11 was applied on it according to the pattern formed by the mask 10, thus obtaining the pattern 12.

Only half of the cuprous oxide applied as shown in equation (1) became metallic copper in the disproportionation of the cuprous oxide. It was difficult to raise the ratio. The low density of the metallic copper produced caused the electronic circuit to have an extremely high resistance. Therefore, it is necessary to raise the density of the metallic copper by another method. One of the methods to be generally taken at this time is a physical development. As shown in Fig. 7 (A), cuprous oxide which was not reacted was removed with an aqueous solution of sodium thiosulfate or the like. The pattern 12 on the substrate 3 was retained in the metal salt aqueous solution 13 under a reducing environment as shown in Fig. 7 (B) so as to grow the metal component of the metal salt around the metallic copper with the metallic copper serving as a nucleus. Thus, a copper pattern 14 of high density was produced.

When a precise pattern is desired in the disproportion of cuprous oxide in the weak acidic aqueous solution utilited by this method, the thickness of the weak acidic aqueous solution must be constant across the whole face on which the cuprous oxide is present on it, because the refractive indexes of the light in air and in the weak acidic aqueous solution are different. Therefore, the light cannot be applied on the cuprous oxide until the cuprous oxide put into the weak acidic aqueous solution becomes certain on the surface of that solution. Thus, it was considerably difficult to use this method for making the pattern. Since the acidic aqueous solution caused corrosion when in contact with the metal, use of the solution in the production line was difficult.

In the physical development using the metal salt aqueous solution within the production line, problems such as metal salt aqueous solution exchange, waste processing and so on are undesirably caused.

US-A-3 671 249 discloses the preparation of photosensitive compositions containing cuprous compounds, particularly cuprous nitrate, as the photosensitive component. The compositions are used in photographic materials and processes to provide copper images.

US-A-3 451 813 discloses a technique for producing a printed circuit by forming a pattern of a photoflash sensitive conducting metal precursor such as silver oxide, copper oxide, nickel formate or copper powder on a substrate and photoflashing high intensity radiation for a short duration such as 0.2 to 30 ms onto the pattern to convert it to a coherent conducting metal circuit adherent to the substrate. Preferably, the reaction is conducted in the presence of an oxygen excluding atmosphere to prevent oxidative recombination of the metal film. The precursor may be fusible metals, decomposable metal compounds or reducible metal compounds. The oxygen excluding atmosphere and/or reducing agent may be provided by a photoflash pyrolyzable organic resin binder for the conducting metal precursor.

### SUMMARY OF THE INVENTION

It is the object of the invention to overcome the above mentioned prior art problems and to provide an improved circuit pattern forming method allowing to utilize light induced disproportionation of cuprous oxide with higher yields.

This object is attained by the method of claim 1. Suitable and preferred embodiments of the method are defined in the subclaims.

The circuit pattern forming method of the invention comprises the steps of:
a) providing a substrate with a cuprous oxide layer provided thereon:
b) applying a layer of a light transmission paste on said cuprous oxide layer, wherein the light transmission paste contains on acidic material selected from the group consisting of hydrochloric acid, sulphuric acid, acetic acid and p-toluene sulphonic acid, and a high molecular agent selected from the group consisting of gelatin, polyvinyl alcohol and cellulose acetate, which light transmission paste is transparent to light of a wavelength of 280 nm to 640 nm;
c) irradiating light of a wavelength of 280 nm to 640 nm through said layer of said light transmission paste onto a portion of said cuprous oxide layer corresponding to said circuit pattern to be formed so as to educe metallic copper on the irradiated portion;
d) removing said layer of said light transmission paste; and
e) removing unreacted cuprous oxide to form said circuit pattern on said substrate.

According to a preferred embodiment of the method of the invention, step b) is carried out by said layer of light transmission paste on a support member transparent to said light to form a light transmission sheet, and the paste side of said light transmission sheet is brought into contact with the cuprous oxide layer.

According to another preferred embodiment of the method of the invention, in step c) said light is irradiated through a mask onto said portion of said cuprous oxide layer, said mask having an opening portion corresponding to said circuit pattern.

The light transmission paste of the present invention captures Cu²⁺ of the cuprous oxide on which the light of the wavelength of 280nm to 640nm has been applied.

The paste is applied on the cuprous oxide to come into contact with it and to educe the metallic copper on the irradiatied portion by application of light on said portion.

The metallic deposition paste is also brought into contact with the metal on the substrate to provide metallic copper of high density.

### BRIEF DESCRIPTION OF THE DRAWINGS:

The objects and features of the present invention will become apparent from the following description taken in conjunction with the preferred embodiment thereof with reference to the accompanying drawings, in which;
Fig. 1 is a step sectional view showing a circuit pattern forming method in a first embodiment of the present invention;
Fig. 2 is a step sectional view showing a circuit pattern forming method in a second embodiment of the present invention;
Fig. 3 is a step sectional view showing a circuit pattern forming method in a third embodiment of the present invention;
Fig. 4 through Fig. 6 are step sectional views showing the conventional circuit pattern forming method; and
Fig. 7 is a step sectional view showing the conventional metallic copper deposition method.

### Embodiment:

Before the description of the present invention proceeds, it is to be noted that like parts are designated by like reference numerals throughout the accompanying drawings.

### Embodiment 1

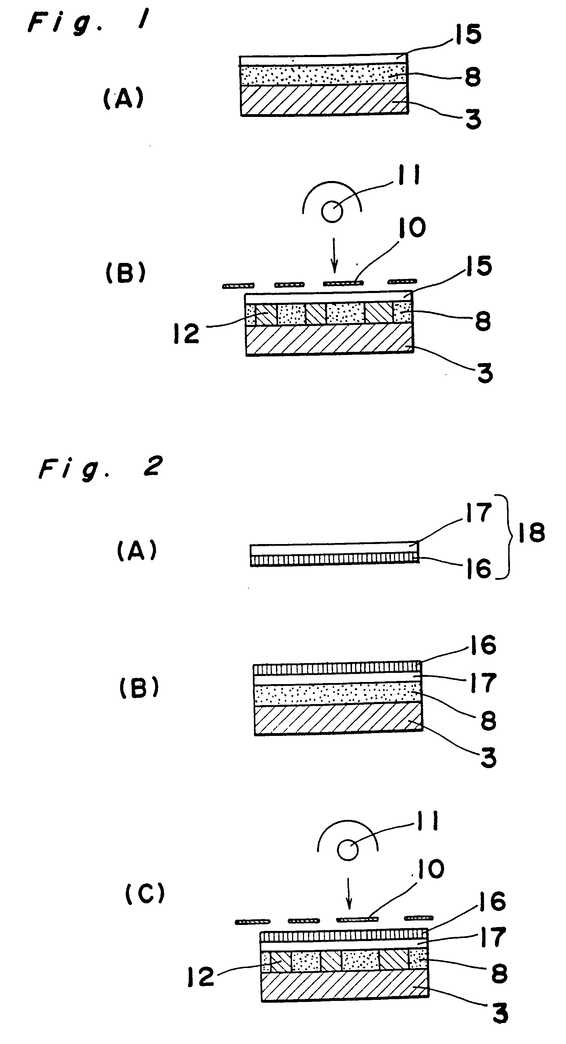

Fig. 1 (A), (B) are sectional views showing the circuit pattern forming method in a first embodiment of the present invention. First, gelatin powder (50g) is added to water (500ml). It is heated to 50°C. 36N-sulphuric acid (0.01ml) is mixed with the gelatin powder completely melted. It is applied on the cuprous oxide 8 applied on the substrate 3 in a dark room. It is cooled and hardened at 5°C into the light transmission membrane 15. Light is applied only in the portion for deposition the metallic copper through a stainless-make mask 10 having an empty hole corresponding to the pattern which is adapted to obtain the light of the light source 11 using a tungsten light as shown in Fig. 1 (B). As a result, the light applied through the mask 10 reaches the cuprous oxide through the light transmission membrane 15. At this time, since the cuprous oxide is put under an acidic environment by the light transmission membrane 15, the disproportionation reaction is caused to educe the metallic copper pattern 12. Finally, the light transmission paste 15 is removed.

The residual cuprous oxide was removed.

Although the stainless-make mask 10 was used for patterning the light in the present embodiment, the light may be in a beam state and may be scanned.

Although gelatin was mixed into the light transmission membrane 15, the other high molecular agents, i.e. polyvinyl alcohol or cellulose acetate may be used. Further, the other acidic reagents hydrochloric acid, acetic acid or p - toluene sulphonic acid may be used instead of sulphuric acid.

### Embodiment 2

Fig. 2 (A), (B), (C) are sectional views showing the circuit pattern forming method in a second embodiment of the present invention. First, gelatin powder (30g) is added into water (500ml). It is heated to 50°C. 36N-sulfuric acid (0.01ml) is mixed with the gelatin powder completely melted. It is applied as a medicine layer 17 on a transparent support member made of cellulose triacetate as shown in Fig. 2 (A), and the light transmission sheet 18 is made. As shown in Fig. 2 (B), it is brought into contact with the cuprous oxide 8 with the medicine layer 17 of the light transmission sheet 18 being applied on the substrate 3. Light is irradiated only upon the portion for patterning, and deposition the metallic copper through a stainless-make mask 10 corresponding to the pattern which is adapted to obtain the light of the light source 11 using a tungsten lamp as shown in Fig. 2 (C). Thus, the light patterned by the mask 10 reaches the cuprous oxide 8 through the transparent support member of the light transmission sheet and the medicine layer 17. At this time, as the cuprous oxide 8 is put under the acidic atmosphere by the medicine layer 17, the disproportioned reaction is caused, and the metallic copper pattern 12 is educed. Finally the light transmission sheet 18 is removed.

Although the stainless-make mask 16 was used for patterning the light in the present embodiment, the light may be in a beam state and may be scanned.

Although gelatin was mixed into the medicine layer 17, the other high molecular agents, i.e. polyvinyl alcohol or cellulose acetate may be used. Also, although cellulose triacetate was used as the transparent support member, polyester or the like which is transparent may be used in at least one portion of the 280nm through 640nm. Further, the other acidic reagents hydrochloric acid, acetic acid, p - toluene sulphonic acid may be used instead of sulphonic acid.

### Embodiment 3

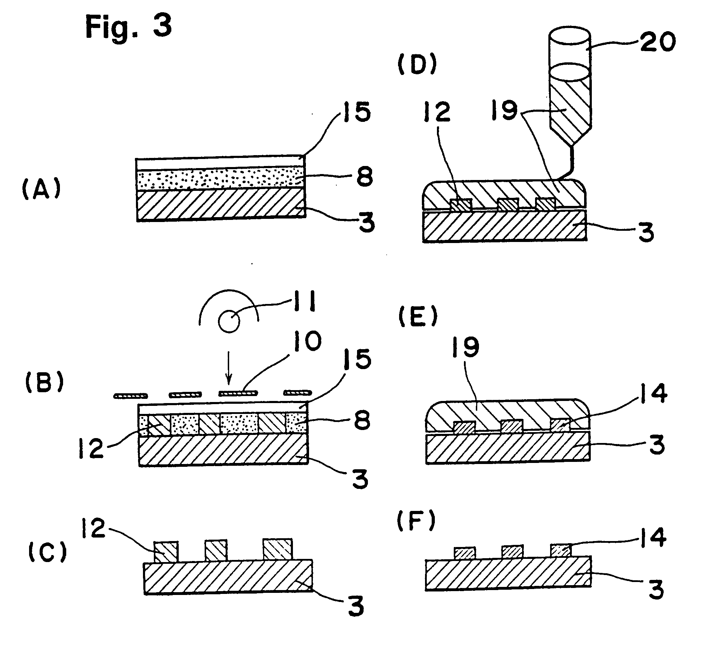

Fig. 3 (A) through (F) are sectional views showing the circuit pattern forming method in a third embodiment of the present invention. First, gelatin powder (50g) is added into water (500ml). It is heated to 50°C. 36N-sulfuric acid (0.01ml) is mixed with the completely melted gelatin powder.

It is applied on the cuprous oxide 8 applied on the substrate 3 in a dark room as shown in Fig. 3 (A). It is cooled and hardened at 5°C into the light transmission membrane 15. Light is irradiated only upon the portion for patterning, and deposition the metallic copper through a stainless-make mask 10 corresponding to the pattern which is adapted to obtain the light of the light source 11 using a tungsten lamp as shown in Fig. 3 (B). Thus, the light patterned by the mask 10 reaches the cuprous oxide through the light transmission membrane 15. At this time, since the cuprous oxide 8 is put under the acidic atmosphere by the light transmission membrane 15, the disproportioned reaction is caused, and the metallic copper pattern 12 is educed.

Thereafter, the light transmission membrane 15 is peeled off. Since the light is not irradiated because of aqueous solution sodium thiosulfate (sodium thiosulfate 25g with respect to water 100ml), the disproportioned reaction is not caused. As a result, the residual cuprous oxide is removed. Thus, only the metallic copper pattern 12 exists on the substrate 3 as shown in Fig. 3 (C).

Then, in order to further improve the conductivity of the metallic copper pattern 12 obtained, the metal deposition paste is used. First, gelatin powder (30g) is added to water 300ml. It is heated at 50°C and is melted completely. Thereafter, hydroquinone 1g, citric acid 0.6g, copper sulfate 1g are added to it to obtain the metallic deposition paste 19. It is applied on the metallic copper pattern 12 formed on the substrate 3 with the use of a nozzle so as to be retained for five minutes as shown in Fig. 3 (D). As a result, the copper of the copper sulfate is educed on the metallic copper pattern 12 as shown in Fig. 3 (E). Then, these are cooled and hardened at 5°C. The metal deposition paste 19 is removed, so that the metallic copper pattern 14 of high density may be formed on the substrate 3 shown in Fig. 3 (F).

Although the stainless-make mask 10 was used for patterning the light in the present embodiment, the light may be in a beam state and may be scanned.

Although gelatin was mixed into the light transmission paste, the other high molecular agents, i.e polyvinyl alcohol or cellulose acetate may be used. Further, the other acidic reagents hydrochloric acid, acetic acid or p - toluene sulphonic acid may be used instead of sulphuric acid. Further, the light transmission sheet of the third may be used without the use of the light transmission paste.

Although gelatin was mixed into the metal deposition paste, another high molecular agent such as cellulose acetate or the like may be used. Also, although acidic hydroquinone was used as the reduction component, another reduction agent such as α - naphthol or the like may be used. Further, although copper sulfate was used as a metal containing component for metal deposition, metallic salts shown by a general equation CuX or CuX₂ (X is Cl, Br, 1, CN, SO₄ or the like) or organic acid metallic salts shown by (RCOO)₂Cu or RCOOCu (R, is alkyl group, acyl group or the like) may be used. Also, in the present embodiment, a nozzle was used for applying the metal deposition paste, another applying method such as printing or the like may be used.

Also, a caution for causing the medicine in paste state to be previously kept in sheet state for the contacting operation may be applied.

As is clear from the foregoing description, according to the arrangement of the present invention, the present invention can educe the metallic copper in the desired portion by applying or contacting the light transmission paste on the cuprous oxide and by applying light on the desired portion.

Also, the light is applied through a mask corresponding to the pattern to be obtained, so that the desired circuit pattern may be easily obtained.

Further, the metallic copper of high density may be educed by contacting or applying the metal deposition paste on the metal of the substrate.

## Claims

1. A circuit pattern forming method comprising the steps of:
a) providing a substrate (3) with a cuprous oxide layer (8) provided thereon:
b) applying a layer of a light transmission paste (15) on said cuprous oxide layer (8), wherein the light transmission paste (15) contains on acidic material selected from the group consisting of hydrochloric acid, sulphuric acid, acetic acid and p-toluene sulphonic acid, and a high molecular agent selected from the group consisting of gelatin, polyvinyl alcohol and cellulose acetate, which light transmission paste (15) is transparent to light of a wavelength of 280 nm to 640 nm;
c) irradiating light of a wavelength of 280 nm to 640 nm through said layer of said light transmission paste (15) onto a portion of said cuprous oxide layer (8) corresponding to said circuit pattern to be formed so as to educe metallic copper on the irradiated portion;
d) removing said layer of said light transmission paste (15); and
e) removing unreacted cuprous oxide to form said circuit pattern on said substrate (3).

2. The method of claim 1, wherein step b) is carried out by said layer of light transmission paste (15) on a support member (16) transparent to said light to form a light transmission sheet (18), and the paste side of said light transmission sheet (18) is brought into contact with the cuprous oxide layer (8).

3. The method of claim 1 or 2, wherein in step c) said light is irradiated through a mask (10) onto said portion of said cuprous oxide layer (8), said mask (10) having an opening portion corresponding to said circuit pattern.

## Patentansprüche

1. Verfahren zur Erzeugung eines Schaltungsmusters mit den Schritten, dass man
a) ein Substrat (3) bereitstellt, auf dem eine Schicht (8) aus Kupfer(I)oxid vorgesehen ist;
b) auf der Schicht (8) aus Kupfer(I)oxid eine Lichtdurchlässigkeitspaste (15) aufbringt, wobei die Lichtdurchlässigkeitspaste (15) ein saueres Material enthält, ausgewählt aus der Gruppe bestehend aus Chlorwasserstoffsäure, Schwefelsäure, Essigsäure und p-Toluolschwefelsäure, und einen hochmolekularen Stoff enthält, ausgewählt aus der Gruppe bestehend aus Gelatine, Polyvinylalkohol und Celluloseacetat, wobei die Lichtdurchlässigkeitspaste (15) gegenüber Licht mit einer Wellenlänge von 280 nm bis 640 nm durchlässig ist;
c) durch die Schicht der Lichtdurchlässigkeitspaste (15) auf einen Teil der Schicht (8) aus Kupfer(I)oxid, der dem zu erzeugenden Schaltungsmuster entspricht, mit einer Wellenlänge von 280 nm bis 640 nm einstrahlt, um auf dem bestrahlten Teil metallisches Kupfer hervorzubringen;
d) die Schicht der Lichtdurchlässigkeitspaste (15) entfernt; und
e) nicht umgesetztes Kupfer(I)oxid entfernt, um auf dem Substrat (3) das Schaltungsmuster zu erzeugen.

2. Verfahren nach Anspruch 1, bei dem man Schritt b) so durchführt, dass sich die Lichtdurchlässigkeitspaste (15) auf einem Trageelement (16) befindet, welches gegenüber dem Licht durchlässig ist, wodurch eine Lichtdurchlässigkeitsplatte (18) entsteht, und die Pastenseite der Lichtdurchlässigkeitsplatte (18) in Kontakt mit der Schicht (8) aus Kupfer(I)oxid bringt.

3. Verfahren nach Anspruch 1 oder 2, bei dem man in Schritt c) das Licht durch eine Maske (10) auf den Teil der Schicht (8) aus Kupfer(I)oxid einstrahlt, wobei die Maske (10) einen dem Schaltungsmuster entsprechenden Öffnungsbereich hat.

## Revendications

1. Procédé de formation d'un motif de circuit comprenant les étapes consistant à :
a) produire un substrat (3) avec une couche d'oxyde de cuivre (8) déposée sur celui-ci ;
b) appliquer une pâte transparente à la lumière (15) sur ladite couche d'oxyde de cuivre (8), dans laquelle la pâte transparente à la lumière (15) contient un matériau acide sélectionné parmi le groupe composé d'acide chlorhydrique, d'acide sulfurique, d'acide acétique et d'acide sulfonique p-toluène, et un agent hautement moléculaire sélectionné parmi le groupe composé de gélatine, d'alcool de polyvinyle et d'acétate de cellulose, laquelle pâte transparente à la lumière (15) est transparente à la lumière sur une longueur d'onde comprise entre 280 nm et 640 nm ;
c) irradier une lumière sur une longueur d'onde comprise entre 280 nm et 640 nm à travers ladite couche de ladite pâte transparente à la lumière (15) sur une partie de ladite couche d'oxyde de cuivre (8) correspondant audit motif de circuit devant être formé de façon à réduire le cuivre métallique sur la partie irradiée ;
d) enlever ladite couche de ladite pâte transparente à la lumière (15) ; et
e) enlever l'oxyde de cuivre n'ayant pas réagi, pour former ledit motif de circuit sur ledit substrat (3).

2. Procédé selon la revendication 1, dans lequel l'étape b) est effectuée par ladite couche de pâte transparente à la lumière (15) sur un élément de support (16) transparent à ladite lumière pour former une feuille transparente à la lumière (18) et le côté pâte de ladite feuille transparente à la lumière (18) est mis en contact avec la couche d'oxyde de cuivre (8).

3. Procédé selon la revendication 1 ou 2, dans lequel la phase c) de ladite lumière est irradiée à travers un masque (10) sur ladite partie de ladite couche d'oxyde de cuivre (8), ledit masque (10) présentant une partie d'ouverture correspondant audit motif de circuit.
